Europäisches Patentamt

European Patent Office

Office européen des brevets

(19)

(11) Publication number: **0 194 358 B1**

# EUROPEAN PATENT SPECIFICATION

(12)

(45) Date of publication of patent specification: **23.10.91**

(51) Int. Cl.⁵: **C04B 35/58**, C04B 41/90, H01L 23/36

(21) Application number: **85116660.3**

(22) Date of filing: **31.12.85**

(54) **Heat sink using a sintered body having high heat-conductivity and method of manufacturing thereof.**

(30) Priority: **11.01.85 JP 2565/85**
**30.05.85 JP 117179/85**

(43) Date of publication of application:
**17.09.86 Bulletin 86/38**

(45) Publication of the grant of the patent:
**23.10.91 Bulletin 91/43**

(84) Designated Contracting States:
**DE FR GB IT NL SE**

(56) References cited:
| | |
|---|---|
| **EP-A- 0 019 003** | **EP-A- 0 142 282** |
| **DE-B- 2 111 180** | **FR-A- 2 344 642** |
| **FR-A- 2 395 948** | **GB-A- 1 005 425** |
| **GB-A- 2 051 474** | **US-A- 3 894 850** |
| **US-A- 4 188 194** | **US-A- 4 287 164** |
| **US-A- 4 375 517** | **US-A- 4 409 193** |
| **US-A- 4 469 802** | |

**PATENT ABSTRACTS OF JAPAN, vol. 7, no. 88 (E-170)[1233], 12th April 1983; & JP - A - 58 15241 (SUMITOMO DENKI KOGYO K.K.) 28-01-1983**

(73) Proprietor: **SUMITOMO ELECTRIC INDUS-TRIES, LTD.**
**5-33, Kitahama 4-chome, Chuo-ku**
**Osaka-shi, Osaka 541(JP)**

(72) Inventor: **Sumiya, Hitoshi c/o Itami Works of Sumitomo Electric Ind. Ltd. 1-1 Koyakita 1-chome**
**Itami-shi, Hyogo-ken(JP)**
Inventor: **Sato,Shuichi c/o Itami Works of Sumitomo Electric Ind. Ltd. 1-1 Koyakita 1-chome**
**Itami-shi, Hyogo-ken(JP)**
Inventor: **Yazu, Shuji c/o Itami Works of Sumitomo Electric Ind. Ltd. 1-1 Koyakita 1-chome**
**Itami-shi, Hyogo-ken(JP)**

(74) Representative: **Patentanwälte Kirschner & Grosse**
**Forstenrieder Allee 59**
**W-8000 München 71(DE)**

U.S. DEPARTMENT OF COMMERCE - NATION-
AL TECHNICAL INFORMATION SERVICE -
NTIS FOREIGN TECHNOLOGY SERIES; T.
ENDO "Production of cubic boron nitride";
NTN83-0288 (H) 1983

## Description

The present invention relates to a heat sink using a sintered body having high heat-conductivity to be used for example in a semiconductor laser, a microwave device or an IC device, and a method of manufacturing of the above stated heat sink using a sintered body.

Description of the Prior Art

Cubic system boron nitride (hereinafter referred to simply as cBN) possesses hardness next to that of diamond and it has extremely excellent characteristics in thermal and chemical stability. Therefore, special interest has been attracted toward cubic system boron nitride as the material for a working tool. In addition, cBN has high heat-conductivity also next to that of diamond and accordingly, it is expected to be used for purposes such as the material of a heat-radiation substrate.

As the material of a heat-radiation substrate, various materials having characteristics as shown in Table 1 have been used conventionally.

## Table 1

| Material | Characteristics | | | |
|---|---|---|---|---|
| | Heat Conductivity (at room temperature) W/cm·°C | Thermal Expansion Coefficient (at room temperature to 400°C) | Permittivity (1 MHz at room temperature) | Resistivity (at room temperature) $\Omega \cdot cm$ |
| SiC | 2.7 | 3.7 | 45 | $10^{13}$ |
| BeO | 2.6 | 7.6 | 6~8 | $10^{14}$ |
| AlN | 0.6~1.6 | 4.0 | 8 | $10^{12}$ |
| $Al_2O_3$ | 0.2 | 6.7 | 8~10 | $10^{14}$ |
| Si | 1.3 | 3.6 | 12 | $10^{-3~3}$ |
| Diamond | 20 | 2.3 | 5.7 | $10^{16}$ |

From Table 1, it is understood that diamond has extremely high heat-conductivity compared with other materials.

On the other side, Slack predicted in J. Phys. Chem. Solids, Vol. 34 (1972) page 321 that pure single crystal cBN would have heat-conductivity as high as approximately 13 W/cm·°C at room temperature and suggested the possibility of using it as the material of a radiation substrate.

However, large-sized cBN single crystal has not been obtained yet and accordingly, the heat-conductivity of 13 W/cm·°C has not been confirmed.

In addition, the largest value reported up to the present as the heat-conductivity of a cBN sintered body containing a binding phase is only 2 W/cm·°C. The reason for this is supposed to be that the binding phase acts as an important factor of phonon scattering, causing the heat-conductivity to be lowered excessively.

Furthermore, as a method for manufacturing a high heat-conductivity cBN sintered body not containing a binding phase, U.S. Patent No. 4,188,194 issued on February 12, 1980 for example discloses a method in which a high density cBN sintered body having high heat-conductivity is manufactured by a direct conversion process using pyrolysis type boron nitride (pBN) as the starting raw material.

However, in the method of the U.S. Patent No. 4,188,194, very high pressure and high temperature conditions of 7GPa and 2000° C or more respectively are required to manufacture a sintered body having heat-conductivity of 4 W/cm·°C or more and there is also a problem in reproducibility. In addition, pBN is a very expensive material.

On the other hand, a method for manufacturing a cBN sintered body not containing a binding phase under relatively mild conditions and at low cost is disclosed for example in the paper by Wakatsuki et al. in Mat. Res. Bull, Vol. 7 (1972) page 999, in which a cBN sintered body is obtained by a direct conversion process using hexagonal system boron nitride of low degree of crystallization.

However, the hBN of low degree of crystallization used as the starting raw material lacks chemical stability and is liable to react with the oxygen in the air, which makes it difficult to obtain a homogenous body uniformly and sufficiently sintered overall.

The inventors of the present application conducted experiments on synthetic materials using various methods in order to manufacture a heat sink using a sintered body of high heat-conductivity at low cost and with good reproductivity. As a result, they found it most suitable to use methods as disclosed in USP 4,469,802 issued to Endo et al. on September 4, 1984 where boron nitride of an alkaline earth metal or alkali metal is mixed and then the material is subjected to a high temperature of 1350° C or above under a thermodynamically stabilized pressure condition of cBN. Although the method in this prior art intends primarily to provide a sintered body having good light-transmitting property, not to provide a sintered body having good heat-conductivity, a part or all of the added boro-nitride is diffused and removed out of the system in the above stated method at the time of sintering under a high pressure and in consequence, a sintered body comprised of substantially 100 % cBN can be easily obtained.

As a result of measuring the heat-conductivity of a sintered body obtained as described above, it was made clear that the heat-conductivity of such a sintered body was a relatively high value of 2 to 3 W/cm·°C on the average compared with other sintered bodies using binding materials. However, it was also made clear that the heat-conductivity of such a sintered body was in some cases as low as 1.7 W/cm·°C and thus the measured values were scattered in a rather wide range.

## SUMMARY OF THE INVENTION

Therefore, an object of the present invention is to provide a heat sink using a sintered body of cBN having good heat-conductivity which can be manufactured stably at low cost.

The inventors of the present application conducted many experiments under various conditions and as a result, they discovered that the heat-conductivity of a sintered body depends not on the conditions of sintering but considerably on the composition of the material before it undergoes the sintering treatment, that is, the amount of addition of alkaline earth metal boron nitride or alkali metal boron nitride to hBN. In addition, it was also made clear that it is necessary to control the amount of addition of alkaline earth metal boron nitride or alkali metal boron nitride within a range of from 0.6 mol % to 1.2 mol %.

Accordingly, the present invention intends to provide a heat sink using a sintered body comprising substantially 100% cubic system boron nitride (cBN), wherein
- said sintered body is obtained by uniformly diffusing boron nitride of an alkaline earth metal or of an alkali metal in an amount from 0.6 mol-% to 1.2 mol-% into a preformed body of hexagonal system boron nitride and
- applying a sintering treatment to said body at a high pressure and at a temperature of 1350° C and above under a thermodynamically stabilized condition of the cubic system boron nitride, and wherein
- the amount of impurities including alkali metals or alkaline earth metals from the catalyst in said sintered body is 0.5 % by weight or less,
- the average unit particle diameter of said sintered body is 5 μm or more, and
- the heat conductivity of said sintered body is 4 W/(cm·°C) and above at room temperature.

These object and other objects, features, aspects and advantages of the present invention will become more apparent from the following detailed description of the present invention when taken in conjunction with the accompanying drawings.

## BRIEF DESCRIPTION OF THE DRAWINGS

Fig. 1 is a graph showing a relation between the treatment temperature for diffusion of $Mg_3B_2N_4$ into a hBN body and the added amount of $Mg_3B_2N_4$.

Fig. 2 is a graph showing a relation between the heat-conductivity of a sintered body of the present invention and the added amount of $Mg_3B_2N_4$ into the hBN as the raw material.

Fig. 3 is a graph showing a relation between the unit particle diameter of a sintered body of the present

4

EP 0 194 358 B1

invention and the added amount of $Mg_3B_2N_4$ into the hBN as the raw material.

Fig. 4 is a graph showing a relation between the Vicker's hardness of a sintered body of the present invention and the heat-conductivity thereof.

Figs. 5A and 5B are respectively plane and side sectional views showing an IC device where the first example of a heat sink in accordance with the present invention is applied.

Figs. 6A and 6B are respectively plane and side sectional views of an IC device where the second example of a heat sink in accordance with the present invention is applied.

Figs. 7A and 7B are respectively plane and side sectional views of an IC device where the third example of a heat sink in accordance with the present invention is applied.

Figs. 8A and 8B are respectively plane and side sectional views of an IC device where the fourth example of a heat sink in accordance with the present invention is applied.

Figs. 9A and 9B are respectively plane and side sectional views of an IC device where the fifth example of a heat sink in accordance with the present invention is applied.

Figs. 10A and 10B are respectively plane and side sectional views of an IC device where the sixth example of a heat sink in accordance with the present invention is applied.

Figs. 11A and 11B are respectively plane and side sectional views of an IC device where the seventh example of a heat sink in accordance with the present invention is applied.

Figs. 12A and 12B are respectively plane and side sectional views of an IC device where the eighth example of a heat sink in accordance with the present invention is applied.

Fig. 13 is a partial front section for explaining the process for manufacturing the heat sink of the eighth example.

DETAILED DESCRIPTION OF THE INVENTION

The present invention will be specifically described in the following in connection with a case in which hot-pressed hBN body is used as the raw material and magnesium boron nitride ($Mg_3B_2N_4$) is used as an additive.

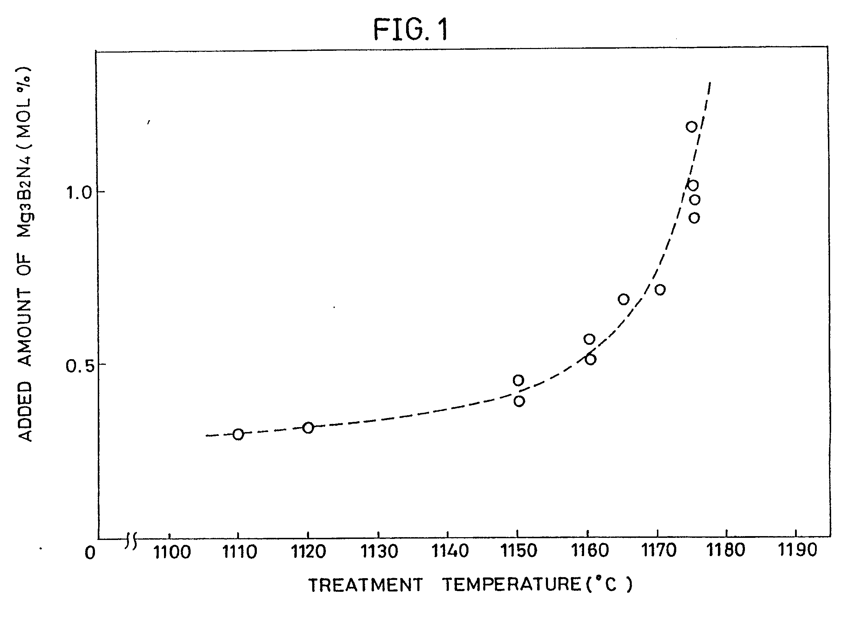

First, an amount of $Mg_3B_2N_4$ was added to the hBN with the temperature condition being changed and thus, a relation as shown in Fig. 1 was established between the treatment temperature and the added amount to $Mg_3B_2N_4$.

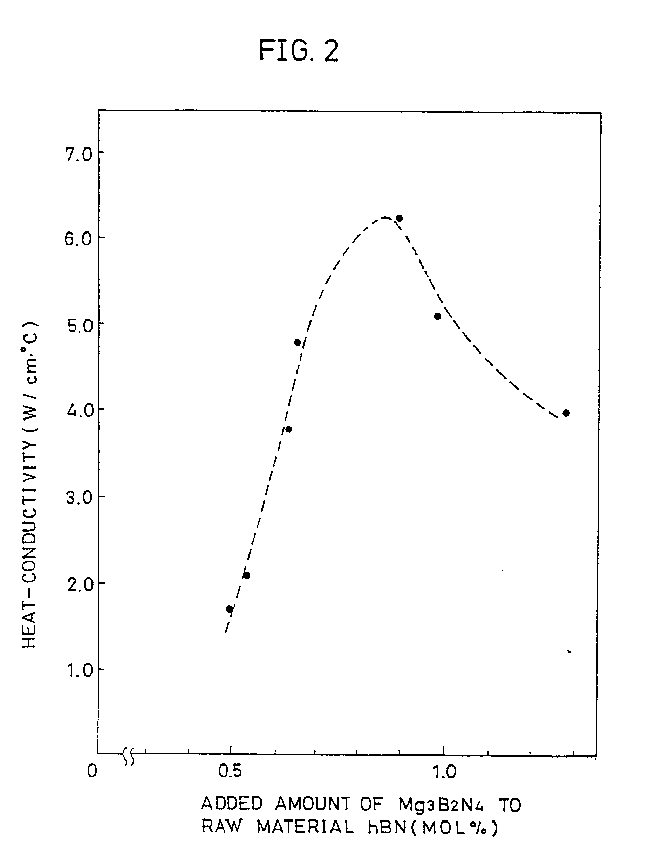

Then, based on the result shown in Fig. 1, several materials containing different amounts of addition of $Mg_3B_2N_4$ were prepared and were subjected respectively to a treatment under prescribed temperature and pressure conditions, whereby sintered bodies were obtained respectively. The heat-conductivity of each of the thus obtained sintered bodies was measured and a relation thereof with the added amount of $Mg_3B_2N_4$ to the material was examined. Fig. 2 shows the results.

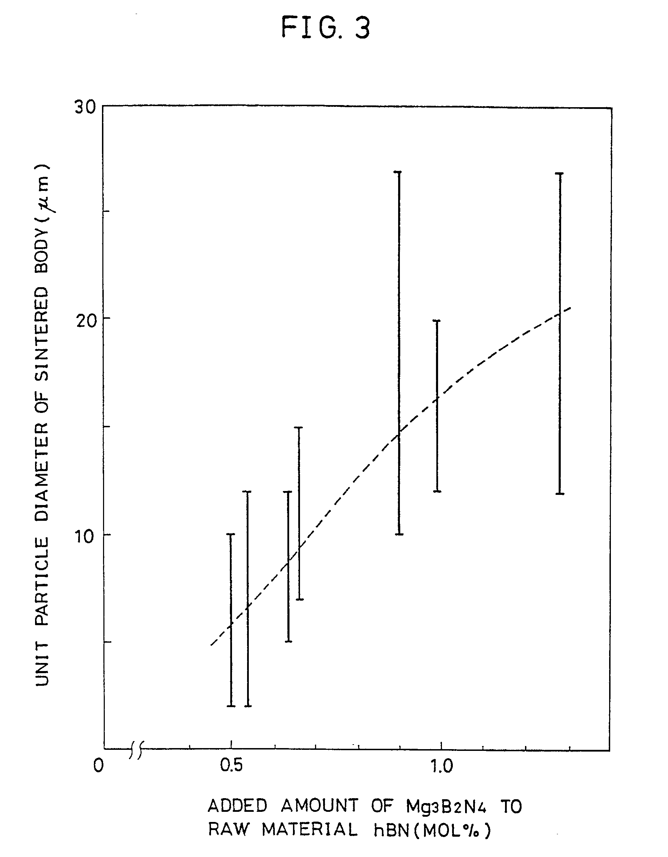

From Fig. 2, it can be seen that in the case of the added amount of $Mg_3B_2N_4$ less than approximately 0.8 mol %, the heat-conductivity rises according to the increase of the added amount of $Mg_3B_2N_4$. This is supposed to be due to the fact that as the added amount of $Mg_3B_2N_4$ increases, the unit particle diameter of cBN becomes large to decrease phoncn scattering in the particle boundary, which results in the heat-conductivity being high. Fig. 3 shows a relation between the added amount of $Mg_3B_2N_4$ and an average unit particle diameter of an obtained sintered body. From Fig. 3, it can be understood that the particle diameter becomes large according to the increase of the added amount of $Mg_3B_2N_4$.

However, from Fig. 2, it can be seen that the heat-conductivity has the maximum value 6.2 W/cm $\cdot$ °C with the added amount of $Mg_3B_2N_4$ being about 0.9 mol % and it is lowered reversely with the added amount of $Mg_3B_2N_4$ being more than 0.9 mol %. If $Mg_3B_2N_4$ is added in an amount of more than 0.9 mol %, the obtained sintered body contains Mg of more than 0.5 % by weight. This remaining Mg is considered to act as a determining cause of phonon scattering, causing the heat conductivity to be lowered.

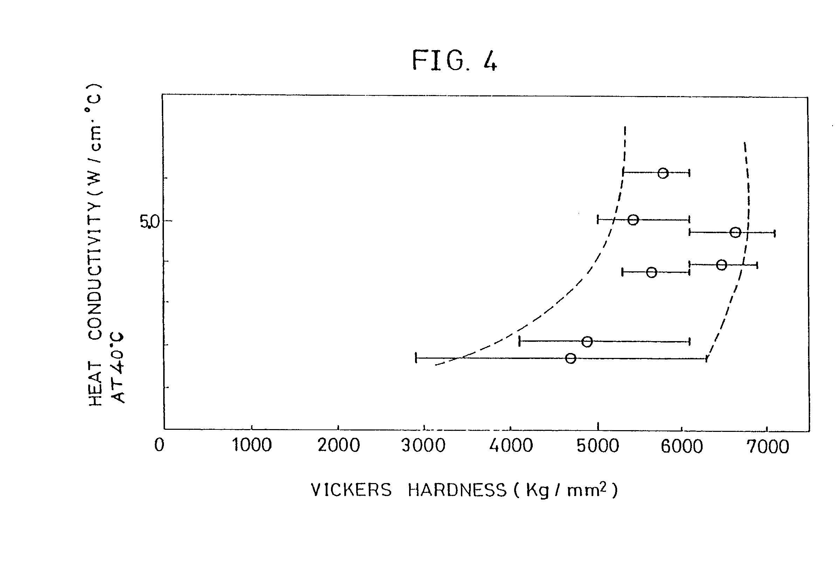

Fig. 4 shows a relation between the heat-conductivity of the respective sintered bodies synthesized with the added amount of $Mg_3B_2N_4$ being changed and the Vickers hardness thereof. It can be seen from Fig. 1 that a sintered body having heat-conductivity in a range from 2 to 3 W/cm $\cdot$ °C has hardness partially lowered and the sintered state thereof is not uniform. It is supposed that in the portion where the sintered state is not good, that is, in the portion where the hardness is lowered, phonon scattering in the particle boundary develops conspicuously on account of insufficient bonding of particles and as a result, the sintered body as a whole has a relatively low value of heat-conductivity. On the other hand, a sintered body having uniform hardness of 5000 kg/mm$^2$ or more possesses heat-conductivity 4 W/cm $\cdot$ °C or above. From the relation between the added amount of $Mg_3B_2N_4$ and the heat-conductivity shown in Fig. 2, it is understood that a sintered body having high heat-conductivity of 4 W/cm $\cdot$ °C or above can be stably obtained with the added amount of $Mg_3B_2N_4$ being in a range from 0.6 mol % to 1.2 mol %.

5

Furthermore, the inventors of the present application also discovered that in a cBN sintered body, (a) the volume ratio of the cubic system boron nitride in the sintered body, (b) the lattice constant of the boron nitride in the sintered body and (c) the proportion of substantial continuity with the adjoining particle of the cubic system boron nitride particle surface contribute to the heat-conductivity. More specifically, as a result of measuring heat conductivity with the volume ratio of the cubic system boron nitride in a sintered body being changed from 60 % to 100 %, it was found that the heat-conductivity of a sintered body having a volume ratio of 95 % or more becomes remarkably high and any sintered body having a volume ratio of 98 % or more has heat-conductivity of 4 W/(cm $\cdot$ $^{\circ}$C) or above. Accordingly, the volume ratio of the CBN in the CBN sintered body is preferably 98 % or more.

In addition, the sintering conditions were selected so that the lattice constant of the cubic system boron nitride may be changed from 3.608 Å to 3.630 Å, and under those conditions, the heat-conductivity was measured. As the result, the maximum value of the heat-conductivity was exhibited in the vicinity of 3.615 Å and high values of heat-conductivity of 4.0 W/(cm $\cdot$ $^{\circ}$C) and above were shown in a range from 3.610 Å to 3.625 Å. Accordingly, the lattice constant of the cBN in the cBN sintered body is preferable in a range from 3.610 Å to 3.625 Å. This is because a deviation from the stoichiometrical BN would increase lattice defects to cause phonon scattering. In such case, if the amount of nitrogen is small, the lattice constant would be increased.

The inventors of the present application manufactured sintered bodies with the sintered conditions being changed and the binding state of the cubic system boron nitride particle was observed by wrapping the sintered bodies thus obtained. Then, the heat-conductivity values of those sintered bodies were measured and it was made clear that a sintered body having substantial continuity of 60 % or more with the adjoining particles has a high value of heat-conductivity of 4.0 W/(cm $\cdot$ $^{\circ}$C) or above. The reason for this is considered to be that the influence of phonon scattering in the particle boundary contributes to the heat-conductivity.

According to the present invention, a heat sink using a cBN sintered body obtained as described above exhibits heat-conductivity as high as 4.0 W/(cm $\cdot$ $^{\circ}$C) and above and consequently, it becomes possible to provide a heat sink of an excellent quality for use in an electronic device.

A sintered body having heat-conductivity of 4 W/cm $\cdot$ $^{\circ}$C or above has a particle diameter of 5 $\mu$m or more, a Vickers hardness of 5000 kg/mm$^2$ or more and a content of Mg of 0.5 % by weight or less. This means that from the hardness and the impurity content, to the contrary, the heat-conductivity of the sintered body can be known.

(Embodiments)

Example 1

As raw materials were used hBN bodies obtained by forming hBN powder with hot-press method or CIP(cold isostatic pressurizing). The hBN bodies obtained were held in N$_2$gas at 2000~2100 $^{\circ}$C for 4 hours to highly purify them. Impurities containted in the hBN bodies were not more than 0.05 % by weight of O$_2$, not more than 0.02 % by weight of carbon and not more than 200 ppm of metal impurities such as Fe, Ca or the like, and the density of the hBN bodies was in a range of 1.75~1.85 g/cm$^3$.

Under the normal pressure in a nitrogen atmosphere at various temperature in a range from 1160 to 1175 $^{\circ}$C, Mg$_3$N$_2$ was diffused and contained in the hBN of high purity described above and eight specimens having different amounts of Mg$_3$B$_2$N$_4$ in a range from 0.4 to 1.3 mol % were obtained as a result of reaction in the hBN body. These specimens were respectively put in recipients and subjected to the conditions of 5.5 GPa and 1450 $^{\circ}$C for 30 minutes using a belt-type device.

The obtained sintered bodies were monophase high-density sintered bodies each having a diameter of 30 mm and a thickness of approximately 1.5 mm. In the sintered body of specimen 1, the hBN not converted were remaining partially, while the other specimens appeared to be in a homogenously and strongly sintered state over the whole surface. In consequence, it is understood that for 100 % conversion to cBN, the amount of Mg$_3$B$_2$N$_4$ added to the raw material hBN body is required to be approximately 0.60 mol % or more.

From the sintered bodies of specimens 2 to 8, pieces of 2.5 x 2.5 x 1.5 mm were extracted respectively and the heat-conductivity of each piece was measured at room temperature by a direct measuring method using an InSb infrared radiation microscope. The results obtained were shown in Table 2 below.

EP 0 194 358 B1

## Table 2

| Specimen No. | Added Amount | Appearance of Sintered Body | Heat-conductivity |
|---|---|---|---|
| 1 | 0.439 mol % | gray and not transparent | not measured (partially white) |
| 2 | 0.498 mol % | gray and not transparent | 1.7 W/cm·°C |
| 3 | 0.544 mol % | gray and not transparent | 2.1 W/cm·°C |
| 4 | 0.639 mol % | green and semi-transparent | 3.8 W/cm·°C |
| 5 | 0.665 mol % | bluish green and semi-transparent | 4.8 W/cm·°C |
| 6 | 0.909 mol % | bluish green and semi-transparent | 6.2 W/cm·°C |
| 7 | 0.995 mol % | brown and semi-transparent | 5.1 W/cm·°C |
| 8 | 1.291 mol % | brown and semi-transparent | 4.0 W/cm·°C |

It is understood from Table 2 that a sintered body obtained with the added amount of $Mg_3B_2N_4$ to the material hBN body being in a range from 0.6 mol % to 1.2 mol % has heat-conductivity of approximately 4 W/cm·°C or above.

Example 2

For the purpose of examining the characteristics required for a sintered body of the heat-conductivity, the particle diameter, the hardness and the impurity content of each of the specimens 2 to 8 obtained in the example 1 were measured.

The particle diameter was measured by a scanning type electronic microscope (SEM) after the surface of each specimen was etched with KOH to make clear the particle boundaries.

The hardness was examined by using a Vicker's penetrator under the load of 10 kg for 15 seconds.

The content of impurity, that is the content of Mg was measured by using an ion microanalyzer.

The results are shown in Table 3.

7

Table 3

| Specimen No. | Particle Diameter ($\mu$m) | Vickers Hardness (kg/mm$^2$) | Mg content (% by weight) |
|---|---|---|---|
| 2 | 2~10 | 2900~6300 | < 0.1 |
| 3 | 2~12 | 4100~6100 | < 0.1 |
| 4 | 5~12 | 5300~6100 | 0.1 |
| 5 | 7~15 | 6100~7100 | 0.1 |
| 6 | 10~17 | 5300~6100 | 0.3 |
| 7 | 12~20 | 5000~6100 | 0.5 |
| 8 | 12~27 | 6100~6900 | 0.7 |

Impurities other than Mg were analized by using an ion microanalyzer for each specimen and C, Al, Ca and Si were detected, the amount of each of them being less than 200 ppm.

From the example 1 and the results shown in Table 3, it is understood that a sintered body having heat-conductivity of 4W/cm•°C or above has a unit particle diameter of 5 $\mu$m or more, Vickers hardness of 5000 kg/mm$^2$ or more and the Mg content of 0.5 % by weight or less.

Example 3

Instead of the $Mg_3B_2N_4$ in the example 1, $Li_3BN_2$, $Ca_3B_2N_4$ and $Sr_3B_2N_4$ were respectively diffused and contained in an amount of from 0.6 to 1.2 mol % in the hBN and sintered bodies were obtained in the same manner as in the example 1. In all of the sintered bodies thus obtained, the heat-conductivity was 4W/cm•°C or above and the particle diameter, the hardness and the impurity content were almost the same as the results of the example 2.

Example 4

hBN bodies containing 0.8~0.9 mol % of $Mg_3B_2N_4$ were obtained in the same manner as in the Example 1. After that, the body was put in a recipient and using a belt-type device, six sintered bodies were formed under the conditions of 55 kb and 1400°C, with the holding time being changed. The proportions of transformation to cubic system boron nitride in the obtained sintered bodies were respectively 60 %, 80 %, 90 %, 95 %, 98 % and 100 %. The remaining portions were compounds of the hexagonal system boron nitride not transformed and the catalyst.

The heat-conductivity of each of the above stated sintered bodies was measured and the results are shown in Table 4 below.

From Table 4, it is understood that a sintered body having a volume ratio of cubic system boron nitride of 98 % or more has heat-conductivity as high as 4.0 W/(cm•°C) or above.

## Table 4

| Items No. | 1 | 2 | 3 | 4 | 5 | 6 |
|---|---|---|---|---|---|---|
| Sintering Pressure | 55kb | → | → | → | → | → |
| Sintering Temperature | 1400°C | → | → | → | → | → |
| Holding Time | 2min. | 5min. | 10min. | 15min. | 20min. | 30min. |
| Transformation Ratio | 60 % | 80 % | 90 % | 95 % | 98 % | 100 % |
| Heat-Conductivity | 0.2 | 0.4 | 0.9 | 1.8 | 4.1 | 5.5 |

Example 5

As a raw material, a hexagonal system boron nitride body containing uniformly dispersed 0.6~0.9 mol % of $Mg_3B_2N_4$ was prepared, and the material thus prepared was put in a recipient of Mo. Then, it was subjected to treatment under the conditions of 57 kb and 1450° C with the temperature being raised by two steps and sintered bodies were obtained. By changing the holding time in the first step, the lattice constants of the cubic system boron nitride of the sintered bodies were made different.

Table 5 shows the results of measurement of the heat-conductivity values of the these sintered bodies.

From Table 5, it is understood that a high value of heat-conductivity of 4.0 W/(cm·° C) or above was exhibited with the lattice constant of the cubic system boron nitride being in a range from 3.610 Å to 3.625 Å.

It is to be noted that the sintering time shown in Table 5 was 20 minutes in each case.

Table 5

| Items | Specimen No. | | | | |
|---|---|---|---|---|---|
| | 1 | 2 | 3 | 4 | 5 |
| Sintering Pressure | 57kb | → | → | → | → |
| Sintering Temperature (in the second step) | 1450°C | → | → | → | → |
| Raised Temperature in the first step | 1250°C | → | → | → | → |
| Holding Time in the first step | 1 min. | 10 min. | 20 min. | 40 min. | 60 min. |
| Lattice Constant Å | 3.630 | 3.624 | 3.617 | 3.613 | 3.608 |
| Heat—Conductivity W/cm·°C | 2.0 | 4.3 | 5.9 | 6.0 | 3.4 |

Example 6

As a material, a hexagonal system boron nitride body containing uniformly dispersed 0.8~0.9 mol % of $Mg_3B_2N_4$ was prepared and this material was put in a recipient. Then, using a belt-type device, the temperature was raised by two steps under the conditions of 55 kb and 1450° C, whereby sintered bodies were formed with the holding time in the second step being changed in this example. The sintered bodies thus obtained were wrapped with fine power of diamond and then, particle boundary was checked by using a scanning type electronic microscope. As a result, it was ascertained that the hexagonal system boron nitride particles were substantially continuous with the surrounding adjacent particles and no particle boundary was observed.

In addition, a relation between an average value of the surface proportion of continuity and the heat-conductivity was examined and the result is shown in Table 6 below.

Table 6

| Items \ Specimen No. | 1 | 2 | 3 | 4 | 5 |
|---|---|---|---|---|---|
| Proportion of continuity | 40 % | 50 % | 60 % | 80 % | 85 % |
| Heat-conductivity W/cm·°C | 2.3 | 2.9 | 4.0 | 4.5 | 6.1 |

As described previously, U.S. Patent No. 4,188,194 discloses a metallization technique in which the surface of cubic system boron nitride is coated with Ni by sputtering and further coated with silver.

However, such coating film has disadvantages that the adhesion to the cubic system boron nitride sintered body is insufficient and accordingly, they are liable to be detached at the time of inserting the heat sink in a cooper substrate. By contrast, in a heat sink using a CBN sintered body of the present invention, the above stated disadvantages have been dissolved and coating films having an excellent adhesion property can be provided. More specifically, a sintered body of the present invention may be provided with on its surface, coating layers of one or more transition metals of the groups IVa, Va and VIa of the periodic table or the alloys thereof. In this case, boride, nitride or boron nitride of such metals is formed in the interface, which makes it possible to remarkably increase the adhesion intensity of the coating films.

In addition, in the present invention, one or more coating layers of metals not oxidized at a temperature of 300° C or alloys thereof may be provided for purpose of preventing oxidation of the metal of the coating films. As the metals not oxidized at a temperature of 300° C, Au, Ag, Cu, Pt, Al, Ni, Co and the like are preferred. The temperature of 300° C is based on the fact that the maximum temperature necessary for adhesion between a semiconductor device and lead wires, between the semiconductor device and the sink, and between the heat sink and the substrate is approximately 300° C.

Example 7

The sintered body of specimen 4 in the example 5 was cut into 20 pieces each having a size of 1 mm² and 0.4 mm thickness. After that, those pieces were heated to a high temperature and Ti was coated to a thickness of 500 Å on the surface of each piece. Subsequently, was further coated to a thickness of 1 μm on the Ti coating layer. Then, a semiconductor laser device was soldered on each sintered body thus formed and leads were connected.

For comparison, a BeO body was cut into 20 pieces each having the same size as described above and in the same manner, coating was applied and semiconductor laser devices of the same kind were placed.

When electric current of 150 mA was made to flow, the surface temperature of each device was measured. As a result, it was observed that the temperature of the devices each provided with a heat sink comprising a cubic system boron nitride sintered body in accordance with the present invention was lowered by approximately 15° C.

In addition, in a scratching test using a sapphire needle, some of the coating films of the heat sinks of BeO were detached, while the coating films on the sintered bodies, in accordance with the present invention were not detached.

Furthermore, the face of contact between cBN sintered body and a coating film was examined by a TEM and there was found titanium borid.

Example 8

The sintered body of specimen 5 in the example 5 was cut into four pieces each having a size of 100 mm² and 0.5 mm in thickness. Then, those pieces were heated and Cr was coated on the surface of each piece and Ni and Ag were further coated thereon. Each of the sintered bodies containing the coating films thus formed was attached to an IC substrate. As a result, it was observed that the IC operated more stably and the lifetime of the IC became remarkably long.

Now, in the following, a concrete structure of a heat sink for an IC using a sintered body in accordance with the present invention will be described.

In the below described case, for the purpose of improving the heat-radiation property, a sintered body is shaped such that the area of the outer surface of the sintered body may be relatively larger than the surface thereof facing the semiconductor device. For the shaping, the following three manners are considered.

(a) The surface area of the heat sink on the side of an envelope is made larger than the area of the portion of the heat sink contacting the IC device so that the heat content per unit area is lowered on the side of the envelope. Thus, the temperature of the heat sink material can be made close to the temperature of the external atmosphere and accordingly, the temperature of the IC device can be lowered effectively.

(b) the surface area of the heat sink in the portion contacting the external gas or liquid is made large so that the heat conduction to the exterior is improved.

(c) Radiation fins are provided in the portion of the heat sink contacting the external gas or liquid so that the heat radiation property is further improved.

The above described heat sink uses a cBN sintered body having excellent heat-conductivity and is shaped such that the area of the outer surface thereof is relatively large compared with the surface thereof on the side facing the semiconductor device and in consequence, heat can be emitted efficiently from the inside of the device to the exterior not only because of the good heat-conductivity of the material itself but also because of its structure.

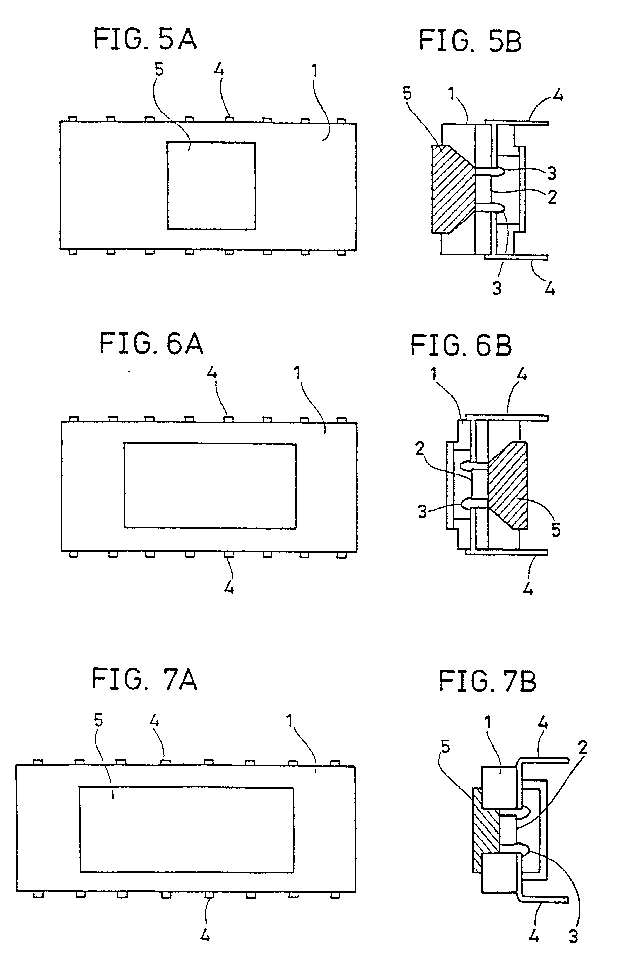

Figs. 5A and 5B are respectively plane and side sectional views of the first example of a heat sink in accordance with the present invention. Referring to Figs. 5A and 5B, a Si device or a compound semiconductor 2 as an IC device is disposed in an envelope 1 and input and output pins 4 are provided through leads 3 connected to the Si device 2.

On the other hand, in the envelope 1 on the side of the Si device 2, a tapered opening is formed, the diameter thereof being small on the inner side and being increased toward the outer surface of the envelope 1. In the opening, a heat sink 5 for IC device in accordance with an embodiment of the present invention is placed. As is clear from Fig. 5B, the heat sink 5 has a form corresponding to the tapered opening and accordingly the surface area thereof on the side of the Si device 2 as the semiconductor device is small and the surface of area thereof on the outer side of the envelope 1, that is on the side contacting the external atmosphere is increased. Thus, as described previously, the heat content per unit area of the heat sink is smaller on the outer side than on the side of the Si device 2 and radiation of heat can be made more efficiently.

Figs. 6A and 6B are respectively plane and side sectional views of an IC device where the second example of a heat sink in accordance with the present invention is applied. In this example, the envelope 1 and the heat sink 5 are formed in the direction in which the input and output pins 4 extend. The other portions are the same as in the example shown in Figs. 5A and 5B. Accordingly, it is understood that heat is radiated efficiently also in the heat sink 5 of this example.

Figs. 7A and 7B are respectively plane and side sectional views of an IC device where the third example of a heat sink in accordance with the the present invention is applied. In this third example, a through hole not tapered is formed in the envelope and the heat sink 5 for IC is placed in the through hole. However, the heat sink 5 in this example extends on the outer side of the envelope 1 over a range wider than the diameter of the through hole. More specifically, the heat sink 5 is provided over an area larger than the opening area so as to be in contact with the outer surface of the envelope 1. Accordingly, also in this example, in the same manner as in the example shown in Figs. 5A and 5B, the surface area of the heat sink 5 on the external side is made larger than that on the side of the Si device 2 and the same radiation effect can be obtained.

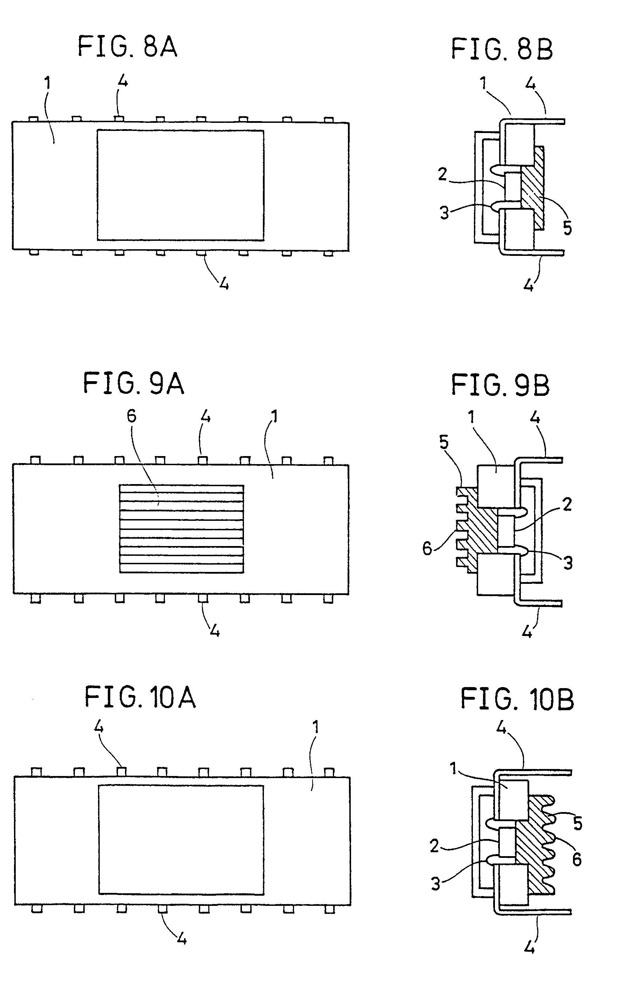

Figs. 8A and 8B are respectively plane and side sectional views of a device where the fourth example of a heat sink in accordance with the present invention is applied. In this fourth example, in the same manner as in the heat sink 5 of the example shown in Figs. 6A and 6B, the envelope 1 and the heat sink 5 for IC are provided in the direction in which the input and output pins 4 extend. The structure of the envelope 1 and heat sink 5 are the same as those in the third example shown in Figs. 7A and 7B and therefore, the same effect can be obtained.

Figs. 9A and 9B are plane and side sectional views of a device where the fifth example of a heat sink in accordance with the present invention is applied. In this fifth example, radiation fins 6 are formed on the external side of the heat sink 5. The other portions are the same as in the example shown in Figs. 7A and 7B. It is understood that the example shown in Figs. 9A and 9B has more excellent radiation characteristic compared with the third example since the radiation fins 6 are provided in this fifth example.

The form of the radiation fins 6 is not limited to that shown in Figs. 9A and 9B. They may have any suitable form as shown in the sixth to eighth examples in Figs. 10A-10B, 11A-11B and 12A-12B. In any of the forms, the area of the fins 6 can be made larger than the outer surface area of the heat sink 5 and accordingly, the heat radiation characteristic can be further improved.

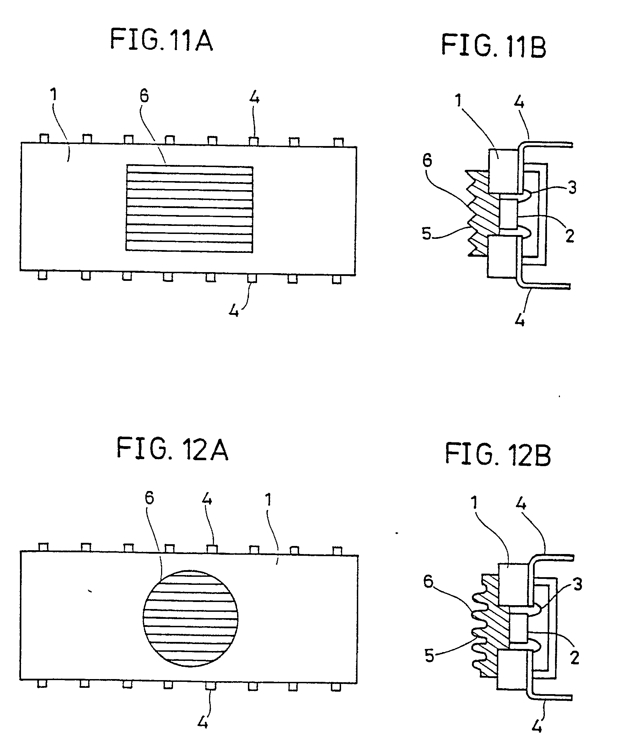

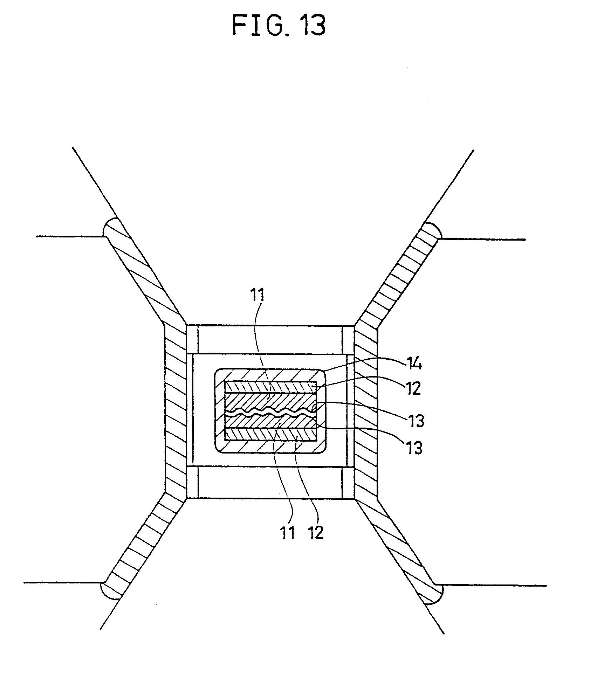

Now, an example of a method of manufacturing a heat sink for IC in accordance with the present invention will be described with reference to the partial from sectional views of Fig. 13. As shown in Fig. 13, in a girdle-type extra-high pressure generating apparatus, cBN bodies 11 containing diffused mangnesium boron nitride are disposed respectively between the ultra-hard alloy plates 12 and the Mo plates 13 of 0.1 mm in thickness shaped according to the form of the radiation fins so that a multilayer structure is formed. The thus formed multilayer structure is placed in a recipient 14 of Mo. Then, under the pressure of 55 kb, the Mo recipient 14 is heated at a temperature of 1450° C for 30 minutes. After that, the sintered bodies 11 are taken out from the Mo recipient 14. In advance, the respective surfaces of the Mo plates 13 disposed between the respective sintered bodies 11 have been coated with a peeling agent so that the multilayer sintered bodies 11 may be easily separated from one another. Therefore, the sintered bodies 11 thus taken out are separated with the Mo plates 13 being attached thereto. The Mo plate 13 attached to the surface of each sintered body 11 is removed for example by treatment using acid such as nitric acid, whereby the same form as that of the radiation fins 6 of the heat sink 5 in the example shown in Figs. 12A and 12B can be obtained.

On the face portion of contact between the thus obtained sintered body 11 and the IC device, a multilayer coating film of Ti and Ni and Au is formed and this coating film is soldered by Au-Sn to the IC logic device, so that the structure thus formed is fixed to the envelope. Thus, the IC device shown in Figs. 12A and 12B can be obtained. For comparison, an IC device as shown in Figs. 12A and 12B was manufactured using a heat sink of BeO and the performances of the heat sinks of both IC devices were tested. In this test, the same electric power and the same electric current were applied and the temperatures on the surface of the envelopes of both IC devices were measured. As a result, it was ascertained that the device using the heat sink of the present invention had a lower temperature and exhibited a more excellent characteristic when it was operated.

Although the present invention has been described and illustrated in detail, it is clearly understood that the same is by way of illustration and example only and is not to be taken by way of limitation.

## Claims

1.  A heat sink using a sintered body comprising substantially 100% cubic system boron nitride (cBN), wherein
    - said sintered body is obtained by uniformly diffusing boron nitride of an alkaline earth metal or of an alkali metal in an amount from 0.6 mol-% to 1.2 mol-% into a preformed body of hexagonal system boron nitride and
    - applying a sintering treatment to said body at a high pressure and at a temperature of 1350° C and above under a thermodynamically stabilized condition of the cubic system boron nitride, and wherein
    - the amount of impurities including alkali metals or alkaline earth metals from the catalyst in said sintered body is 0.5 % by weight or less,
    - the average unit particle diameter of said sintered body is 5 $\mu$m or more, and
    - the heat conductivity of said sintered body is 4 W/(cm $\cdot$ ° C) and above at room temperature.

2.  A heat sink in accordance with claim 1, wherein
    - a coating layer of 1 $\mu$m or less comprised of one or more kinds of transition metal belonging to the groups IVa, Va and VIa of the periodic table or the alloys thereof is formed on the surface of said sintered body having high heat conductivity, and
    - on the face of contact between said sintered body of cBN and said coating layer, boride, nitride or boron nitride is formed by reaction between the metal of said coating layer and the cBN.

3.  A heat sink in accordance with claim 2, wherein one or more second coating layers comprised of a material selected from the group consisting of Au, Ag, Cu, Pt, Al, Ni and Co or the alloys thereof are further formed on the outer surface of said coating layer.

4.  A heat sink in accordance with claim 1, wherein a coating layer comprised of copper or a copper alloy is formed on the surface of said cBN sintered body.

5.  A heat sink in accordance with claim 1 for use as a heat sink for an integrated circuit device, wherein said heat sink is formed such that the area of the outer surface is relatively large as compared with another surface thereof facing a semiconductor device.

6.  A heat sink in accordance with claim 5 for use as a heat sink for an integrated circuit device, wherein radiation fins are formed on said outer surface of said heat sink.

7.  A method for manufacturing a heat sink using a sintered body comprising substantially 100% cubic system boron nitride (cBN), said sintered body being obtained by adding boron nitride of an alkaline earth metal or of an alkali metal as a catalyst to a body of hexagonal system boron nitride (hBN) and sintering said body at a high pressure and at a temperature of 1350° C and above under a thermodynamically stabilized condition of the cubic system boron nitride, wherein
    - the boron nitride of an alkaline earth metal or of an alkali metal is added by uniformly diffusing an amount of 0.6 mol-% to 1.2 mol-% of said catalyst into the body of hexagonal system boron nitride,
    - said sintered body having an amount of 0.5 % by weight or less amount of impurities including alkali metals or alkaline earth metals from the catalyst, an average unit particle diameter of 5 $\mu$m or more and a heat conductivity of 4 W/(cm$\cdot$°C) and above at room temperature.

8. A method in accordance with claim 7, wherein the catalyst is diffused into the body of hexaganol system boron nitride at a temperature of 1160°C to 1175°C.

9. A method in accordance with claim 7, wherein the hexagonal system boron nitride is kept at a temperature of 1250°C for 10 to 40 minutes under a thermodynamically stabilized condition of the cubic system boron nitride before the sintering step.

**Revendications**

1. Dissipateur de chaleur utilisant un corps fritté comprenant un nitrure de bore (cBN) à système pour l'essentiel isométrique à 100 %, dans lequel
   - ledit corps fritté est obtenu en diffusant uniformément du nitrure de bore d'un métal alcalino-terreux ou d'un métal alcalin, en une quantité comprise entre 0,6 mol-% et 1,2 mol-%, dans un corps préformé en nitrure de bore à système hexagonal, et
   - en soumettant ledit corps à un traitement de frittage sous une forte pression, et à une température de 1350°C et au-delà, dans une condition thermodynamiquement stabilisée du nitrure de bore à système isométrique, et dans lequel
   - la quantité d'impuretés, comprenant des métaux alcalins ou des métaux alcalino-terreux provenant du catalyseur, dans ledit corps fritté, représente 0,5 % en poids ou moins,
   - le diamètre corpusculaire moyen dudit corps fritté est de 5 $\mu$m ou plus, et
   - la conductivité thermique dudit corps fritté est de 4 W/(cm.°C) et au-delà, à température ambiante.

2. Dissipateur de chaleur selon la revendication 1, dans lequel
   - une couche de revêtement de 1 $\mu$m ou moins, comprenant un ou plusieurs types de métaux de transition appartenant aux groupes IVa, Va et VIa du tableau périodique, ou les alliages de ces derniers, est formée sur la surface dudit corps fritté présentant une haute conductivité thermique, et
   - un borure, un nitrure ou un nitrure de bore est formé, sur la surface de contact entre ledit corps fritté en cBN et ladite couche de revêtement, par réaction entre le métal de ladite couche de revêtement et le cBN.

3. Dissipateur de chaleur selon la revendication 2, dans lequel une ou plusieurs secondes couches de revêtement, comprenant un matériau sélectionné dans le groupe englobant Au, Ag, Cu, Pt, Al, Ni et Co, ou les alliages de ces derniers, sont en outre formées sur la surface externe de ladite couche de revêtement.

4. Dissipateur de chaleur selon la revendication 1, dans lequel une couche de revêtement, comprenant du cuivre ou un alliage de cuivre, est formée sur la surface dudit corps fritté en cBN.

5. Dissipateur de chaleur selon la revendication 1, destiné à être utilisé en tant que puits de chaleur pour un dispositif à circuits intégrés, dans lequel ledit dissipateur de chaleur est formé de telle sorte que la superficie de la surface externe soit relativement grande comparativement à une autre surface dudit dissipateur, tournée vers un dispositif semiconducteur.

6. Dissipateur de chaleur selon la revendication 5, destiné à être utilisé en tant que puits de chaleur pour un dispositif à circuits intégrés, dans lequel des ailettes de rayonnement sont ménagées sur ladite surface externe dudit dissipateur de chaleur.

7. Procédé de fabrication d'un dissipateur de chaleur utilisant un corps fritté comprenant un nitrure de bore (cBN) à système pour l'essentiel à 100 % isométrique, ledit corps fritté étant obtenu en ajoutant du nitrure de bore d'un métal alcalino-terreux ou d'un métal alcalin, faisant fonction de catalyseur, à un corps en nitrure de bore à système hexagonal (hBN), et en frittant ledit corps sous une forte pression, et à une température de 1350°C et au-delà, dans une condition thermodynamiquement stabilisée du nitrure de bore à système isométrique, dans lequel

- le nitrure de bore d'un métal alcalino-terreux ou d'un métal alcalin est ajouté en diffusant uniformément, dans le corps en nitrure de bore à système hexagonal, une quantité dudit catalyseur comprise entre 0,6 mol-% et 1,2 mol-%,
- ledit corps fritté présentant une quantité de 0,5 % en poids ou moins d'impuretés comprenant des métaux alcalins ou des métaux alcalino-terreux provenant du catalyseur, un diamètre corpusculaire moyen de 5 $\mu$m ou plus, et une conductivité thermique de 4 W/(cm.$^\circ$C) et au-delà, à température ambiante.

8. Procédé selon la revendication 7, dans lequel le catalyseur est diffusé, dans le corps en nitrure de bore à système hexagonal, à une température comprise entre 1160$^\circ$C et 1175$^\circ$C.

9. Procédé selon la revendication 7, dans lequel, préalablement à l'étape de frittage, le nitrure de bore à système hexagonal est maintenu à une température de 1250$^\circ$C pendant 10 à 40 minutes, dans une condition thermodynamiquement stabilisée du nitrure de bore à système isométrique.

**Patentansprüche**

1. Wärmesenke unter Verwendung eines gesinterten Körpers, der im wesentlichen 100% kubisches Bornitrid (cBN) aufweist, wobei
   - der gesinterte Körper durch gleichmäßiges Diffundieren von Bornitrid eines Erdalkalimetalls oder Alkalimetalls in einer Menge von 0,6 Mol-% bis 1,2 Mol-% in einen vorgeformten Körper aus hexagonalem Bornitrid hergestellt wird, und
   - der Körper bei hohem Druck und einer Temperatur von 1350$^\circ$C und mehr bei thermodynamisch stabilisiertem Zustand des kubischen Bornitrids einem Sinterverfahren unterworfen wird, und wobei
   - die Menge an Fremdbestandteilen, einschließlich Alkalimetalle oder Erdalkalimetalle aus dem Katalysator, in dem gesinterten Körper 0,5 Gewichts-% oder weniger beträgt,
   - der durchschnittliche Teilchendurchmesser des gesinterten Körpers 5$\mu$m oder mehr beträgt, und
   - die Wärmeleitfähigkeit des gesinterten Körpers bei Zimmertemperatur 4 W/(cm$\bullet$$^\circ$C) und mehr beträgt.

2. Wärmesenke nach Anspruch 1, wobei
   - eine Überzugsschicht von 1 $\mu$m oder weniger, die aus einem oder mehreren Arten von Übergangsmetallen aus den Gruppen IVa, Va and VIa des Periodensystems oder deren Legierungen besteht, auf der Oberfläche des gesinterten Körpers mit hoher Wärmeleitfähigkeit gebildet wird, und
   - auf der Kontaktfläche zwischen dem gesinterten Körper aus cBN und der Überzugsschicht Borid, Nitrid oder Bornitrid durch eine Reaktion des Metalls der Überzugsschicht mit dem kubischen Bornitird gebildet wird.

3. Wärmesenke nach Anspruch 2, wobei eine oder mehrere zweite Überzugsschichten, die aus einem Werkstoff besteht, der aus der Gruppe, bestehend aus Au, Ag, Cu, Pt, Al, Ni und Co, oder deren Legierungen ausgewählt ist, weiterhin auf der äußeren Oberfläche der Überzugsschicht gebildet werden.

4. Wärmesenke nach Anspruch 1, wobei eine Überzugsschicht, die aus Kupfer oder einer Kupferlegierung besteht, auf der Oberfläche des gesinterten Körpers aus kubischem Bornitrid gebildet wird.

5. Wärmesenke nach Anspruch 1 zur Verwendung als Wärmesenke für ein IC-Bauteil, wobei die Wärmesenke so gebildet ist, daß die Fläche der äußeren Oberfläche im Vergleich mit einer anderen Fläche derselben, die der Halbleitereinrichtung zugewandt ist, verhältnismäßig groß ist.

6. Wärmesenke nach Anspruch 5 zur Verwendung als Wärmesenke für ein IC-Bauteil, wobei auf der äußeren Oberfläche der Wärmesenke Abstrahlungsrippen gebildet werden.

7. Verfahren zur Herstellung einer Wärmesenke unter Verwendung eines gesinterten Körpers, der im wesentlichen 100 % kubisches Bornitrid (cBN) enthält, wobei man den gesinterten Körper dadurch erhält, daß Bornitrid eines Erdalkalimetalls oder eines Alkalimetalls als Katalysator einem Körper aus hexagonalem Bornitrid (hBN) beigegeben wird, und daß der Körper bei hohem Druck und einer Temperatur von 1350° C und mehr bei thermodynamisch stabilisiertem Zustand des kubischen Bornitrids gesintert wird, wobei

- das Bornitrid eines Erdalkalimetalls oder eines Alkalimetalls durch gleichmäßiges Diffundieren einer Menge von 0,6 Mol-% bis 1,2 Mol-% des Katalysators in den Körper aus hexagonalem Bornitrid beigefügt wird,
- wobei der gesinterte Körper einen Anteil von 0,5 Gewichts-% oder weniger an Fremdbestandteilen, einschließlich Alkalimetalle oder Erdalkalimetalld von dem Katalysator, einen durchschnittlichen Teilchendurchmesser von 5 μm oder mehr und bei Zimmertemperatur eine Wärmeleitfähigkeit von 4 W/(cm• ° C) und mehr aufweist.

8. Verfahren nach Anspruch 7, wobei der Katalysator bei einer Temperatur von 1160° C bis 1175° C in den Köper aus hexagonalem Bornitrid eindiffundiert wird.

9. Verfahren nach Anspruch 7, wobei das hexagonale Bornitrid vor dem Sintervorgang bei thermodynamisch stabilisiertem Zustand des kubischen Bornitrids 10 bis 40 Minuten auf einer Temperatur von 1250° C gehalten wird.

# FIG. 1

EP 0 194 358 B1

## FIG. 2

# FIG. 3

FIG. 4

FIG. 5A

FIG. 5B

FIG. 6A

FIG. 6B

FIG. 7A

FIG. 7B

FIG. 8A

FIG. 8B

FIG. 9A

FIG. 9B

FIG. 10A

FIG. 10B

## FIG.11A

## FIG. 11B

## FIG. 12A

## FIG. 12B

# FIG. 13